(19)

**Europäisches Patentamt**
**European Patent Office**
**Office européen des brevets**

(11) **EP 4 026 246 B1**

(12) **EUROPEAN PATENT SPECIFICATION**

(45) Date of publication and mention
of the grant of the patent:
**30.07.2025 Bulletin 2025/31**

(21) Application number: **19766247.1**

(22) Date of filing: **10.09.2019**

(51) International Patent Classification (IPC):
$H03L\ 7/085^{(2006.01)}$ $\quad G04F\ 10/00^{(2006.01)}$
$H03L\ 7/08^{(2006.01)}$

(52) Cooperative Patent Classification (CPC):
**H03L 7/085; G04F 10/005; H03L 7/0802**

(86) International application number:
**PCT/EP2019/074098**

(87) International publication number:
**WO 2021/047758 (18.03.2021 Gazette 2021/11)**

(54) **TIME DIFFERENCE DETERMINING DEVICE**

ZEITDIFFERENZ-BESTIMMUNGSVORRICHTUNG

DISPOSITIF DE DÉTERMINATION DE DIFFÉRENCE TEMPORELLE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**13.07.2022 Bulletin 2022/28**

(73) Proprietor: **Huawei Technologies Co., Ltd.**
**Longgang District**
**Shenzhen,**
**Guangdong 518129 (CN)**

(72) Inventors:
• **LAMANNA, Pasquale**
**80992 Munich (DE)**
• **YAN, Hao**
**80992 Munich (DE)**
• **CARDISCIANI, Danilo**
**80992 Munich (DE)**

(74) Representative: **Roth, Sebastian**
**Mitscherlich PartmbB**
**Patent- und Rechtsanwälte**
**Karlstraße 7**
**80333 München (DE)**

(56) References cited:
EP-A1- 2 940 872    US-A1- 2002 158 662
US-A1- 2007 273 569    US-A1- 2011 133 973
US-A1- 2015 212 494    US-B1- 8 081 013

• PALANIAPPAN ARJUN RAMASWAMI ET AL: "A 0.6 V, 1.74 ps Resolution Capacitively Boosted Time-to-Digital Converter in 180 nm CMOS", 2019 IEEE INTERNATIONAL SYMPOSIUM ON CIRCUITS AND SYSTEMS (ISCAS), IEEE, 26 May 2019 (2019-05-26), pages 1 - 4, XP033574382, ISSN: 2158-1525, ISBN: 978-1-7281-0397-6, [retrieved on 20190429], DOI: 10.1109/ ISCAS.2019.8702624

• WANG ZIXUAN ET AL: "An ADPLL with a MASH 1-1-1 [Delta][Sigma] Time-digital c", MELECON 2014 - 2014 17TH IEEE MEDITERRANEAN ELECTROTECHNICAL CONFERENCE, IEEE, 13 April 2014 (2014-04-13), pages 266 - 270, XP032597874, DOI: 10.1109/ MELCON.2014.6820544

**Description**

<u>TECHNICAL FIELD</u>

The invention relates to determining a time difference between two digital signals, especially for use in a phase-locked loop.

<u>BACKGROUND</u>

High resolution and low power Time-to-Digital Converters (TDC) are required to implement high performances fractional-N All-Digital PLL (ADPLL). A TDC is used to measure the delay between a reference clock and a DCO feedback clock. The TDC output code is provided to the Digital Loop Filter that based on it, decides if the DCO has to be sped up or slowed down to keep the PLL in lock condition (or to help the ADPLL to reach the lock condition if the ADPLL is based on a Binary Phase Detector architecture and the TDC is used only to increase the lock-in range). The most tight specification parameters of the TDC for fractional AD-PLL applications are resolution, linearity, phase noise and power consumption especially when high resolution (i.e. high number of bits) is required.

Linearity and phase noise are not relevant in Binary Phase Detector architectures where the TDC is only used to increase the lock-in range. Low power consumption is probably the most difficult specification to achieve especially when high resolution (ie. high number of bits) is required. The power consumption is intrinsically high in the standard TDC architectures for ADPLL because one of the two inputs of the TDC is the feedback signal from the DCO which, depending from the application, can be at very high frequency.

The basic structure of a TDC is based on a delay line and a number of registers. The delay line can be built with a series of digital buffers, each of them generating a replica of its input signal with a delay equal to TRES. The delayed signals are used to sample the other TDC input and generate the output code.

In an exemplary structure, the TDC is composed of two branches: in a first branch, the reference signal (REF) is delayed and used to sample a DCO feedback signal (DCOFB) while in a second branch, the DCOFB signal is delayed and used to sample the REF signal. The output from the top branch is selected by the output multiplexer (mux) if the REF leads the DCOFB while the output from the bottom branch is selected in case the REF lags the DCOFB. The information on the leading signal is provided by a D-flipflop comparing reference and DCO feedback. In this architecture the resolution is limited by the minimum delay of the buffers in the delay line. This minimum delay depends on the employed technology and is usually too high for many applications. The power consumption is also very high due to the high frequency of the clock DCOFB.

A technique to improve the TDC resolution is the VERNIER approach. In a Vernier TDC, both sampled and sampling signal are delayed with different delays T1 and T2. The TDC resolution is equal to TRES = T2 - T1, it is independent from technology and it can be much smaller than in a standard delay line. This technique, significantly improving the TDC resolution, does not provide any power consumption reduction.

A further exemplary technique for power consumption reduction is the DCO downconversion based on the idea of reducing the power consumption by shifting down the DCO feedback frequency. The DCOFB positive edge then samples the reference in order to create a new signal pCKR running at the reference frequency and synchronized on the first DCOFB positive edge lagging the reference. The new signal pCKR can replace the DCO feedback at the TDC input if the reference leads the DCO but it doesn't provide any information if the REF lags the DCO. For this reason another new signal nCKR is generated sampling the REF on the negative edge of the DCOFB. Each of the two new signals pCKR and nCKR can be provided with the reference at the input of a TDC. From the digital processing of the two output codes (codep, coden) the information about the relative phase between REF and DCOFB can be obtained.

The main issues of this architecture are the:

- Difficult matching of the delays added by the sampling block at the input;
- Complex digital processing at the output and calculation decreasing by a factor 2 the resolution of each TDC;

This architecture is therefore not suitable to achieve a high resolution.

US 2007273569 A1 discloses a time-to-digital converter comprising: a plurality of parallel circuits for receiving a common first clock and for generating a plurality of delayed clocks; a plurality of sampling circuits for receiving and sampling said delayed clocks at an edge of a second clock to generate a plurality of decisions, respectively; and a decoder for receiving said decisions and for generating a digital output accordingly.

US 2011133973 A1 discloses a time measurement circuit measuring the time difference between edges of a first signal and a second signal.

EP 2940872 A1 discloses a time-to-digital converter including a phase interpolation circuit and a time-to-digital conversion circuit.

PALANIAPPAN ARJUN RAMASWAMI ET AL, "A 0.6 V, 1.74 ps Resolution Capacitively Boosted Time-to-Digital Converter in 180 nm CMOS", 2019 IEEE INTERNATIONAL SYMPOSIUM ON CIRCUITS AND SYSTEMS (ISCAS), IEEE, Mai 26 2019, discloses a new vernier delay line time-to-digital converter consisting of a vernier delay line built using capacitive boosting delay buffers capable of amplifying the input time signals higher than the supply and below the ground for driving the subsequent buffers with improved strength even at an ultra-low operating supply voltage.

US 2015212494 A1 discloses a Traveling Pulse Wave Quantization method for converting a time sensitive signal to a digital value.

US 2002158662 A1 discloses a power saving circuitry using predictive logic.

WANG ZIXUAN ET AL, "An ADPLL with a MASH 1-1-1 [Delta][Sigma] Time-digital c", MELECON 2014 - 2014 17TH IEEE MEDITERRANEAN ELECTROTECHNICAL CONFERENCE, IEEE, April 14 2014, discloses an all digital phase-locked loop with a MASH 1-1-1 $\Delta\Sigma$ time-digital converter.

US 8081013 B1 discloses a method for digital phase detection.

## SUMMARY

Accordingly, an object of the present invention is to solve the drawbacks of the prior art.

For example, an object is to provide a time difference determining device, which has a low power consumption and at the same time allows for a very accurate time difference determining.

The object is solved by the features of claim 1 for the apparatus. The dependent claims contain further developments. In the following, parts of the description and drawings referring to embodiments not covered by the claims, are not part of the invention, but are illustrative examples necessary for understanding the invention.

A time difference determining device according to a first aspect of the invention determines a time difference between a first digital signal and a second digital signal. The time difference determining device comprises a first time difference determining branch, comprising a first delay line, in turn comprising N first delay cells, each of the N first delay cells having a first delay, and a second delay line, comprising N second delay cells, each of the N second delay cells having a second delay, the second delay being higher than the first delay. Moreover, the time difference determining device comprises a second time difference determining branch, in turn comprising a third delay line comprising N third delay cells, each of the N third delay cells having the second delay, and a fourth delay line, comprising N fourth delay cells, each of the N fourth delay cells having the first delay. The first digital signal is connected to an input of the first delay line and to an input of the third delay line. The second digital signal is connected to an input of the second delay line and to an input of the fourth delay line. This allows reaching a high resolution.

The time difference determining device additionally comprises N first samplers, each connected between an output of an $n^{th}$ one of the N first delay cells and an output of an $n^{th}$ one of the N second delay cells, adapted to sample an output signal of the nth one of the N first delay cells, when triggered by an output signal of the nth one of the N second delay cells. Moreover, the time difference determining device then comprises N second samplers, each connected between an output of an $n^{th}$ one of the N third delay cells and an output of an nth one of the N fourth delay cells, adapted to sample an output signal of the nth one of the N third delay cells, when triggered by an output signal of the nth one of the N fourth delay cells. This allows for an especially low power consumption. Preferably, the output of each determining branch is a bus including the outputs of all N samplers of each branch.

The time difference determining device additionally includes an output stage, which is configured to receive as a first input signal an output of the first time difference determining branch and as a second input signal an output of the second time difference determining branch. The output stage configured to select one of the first input signal and the second input signal as an output of the time difference determining device, based on the value of one or more pre-defined bits of the first input signal of the output stage and of the second input signal of the output stage. This allows for deciding in a very simple manner if the first input signal or the second input signal is leading.

The output stage is adapted to select the first input signal, if a 1st output bit of both time difference determining branches have a bit value of "0"; the second input signal, if a 1st output bit of both time difference determining branches have a bit value "1", a value "0", indicating no time difference between the first digital signal and the second digital signal, if the 1st output bit of the first time difference determining branch has a bit value of "0" and the 1st output bit of the second time difference determining branch has a bit value of "1", and a value of "0", indicating no time difference between the first digital signal and the second digital signal, if the 1st output bit of the first time difference determining branch has a bit value of "1" and the 1st output bit of the second time difference determining branch has a bit value of "0". This allows for a very simple determining by the output stage.

Preferably, the first digital signal and the second digital signal are rectangle signals. Additionally or alternatively, a pulse frequency of the first digital signal is higher than a pulse frequency of the second digital signal. This is especially useful for application in a phase locked loop where the low frequency signal is the Reference signal and the high frequency signal is the DCO.

Advantageously, all delay cells of the first delay line and all delay cells of the fourth delay line are buffers or inverters having a first delay. In this case, all delay cells of the second delay line and all delay cells of the third delay line are buffers or inverters having a second delay. This allows for a simple implementation.

Further preferably, all delay cells of the first delay line, all delay cells of the second delay line, all delay cells of the third delay line, and all delay cells of the fourth delay line comprise buffers having a third delay. All delay cells of the first delay line and all delay cells of the fourth delay line comprise an output capacitor of a first capacitance, the combination of the respective buffer and output capacitor leading to the first delay of the respective delay cells. All delay cells of the second delay line and all delay cells of the third delay line comprise an output capacitor of a second capacitance, the combination of the respective buffer and output capacitor leading to the second delay of the respective delay cell. This allows for an especially efficient implementation.

Alternatively, also advantageously, all delay cells of the first delay line, all delay cells of the second delay line, all delay cells of the third delay line and all delay cells of the fourth delay line comprise a buffer having a fourth delay. All delay cells of the first delay line and all delay cells of the fourth delay line are connected to a first supply voltage, leading to the first delay of the respective delay cell. All delay cells of the second delay line, and all delay cells of the third delay line are connected to a second supply voltage, lower than the first supply voltage, leading to the second delay of the respective delay cell. This is a simple-to-implement second alternative.

Preferably, the time difference determining device additionally comprises a synchronization estimator adapted to determine an estimate time of synchronization of pulses of the first digital signal and the second digital signal. Moreover, the time difference determining device then additionally comprises an activation switch, adapted to selectively disconnect and connect the first digital signal from the first delay line and from the third delay line, based on the determined estimate time. This allows for significantly reducing the consumption of power, since the time difference determining branches only operate while the first digital signal is connected. Especially, the first digital signal only needs to be connected for a short time around the rising edge or the falling edge of the second signal and not during the entire period of the second digital signal.

Preferably, the synchronization estimator is a frequency counter. This allows for an especially simple implementation.

A digital phase-locked loop according to a second aspect of the invention is provided. It comprises a time difference determining device described earlier, and a digitally controlled oscillator, adapted to generate a digitally controlled oscillator signal, controlled by the time difference between the first digital signal and the second digital signal, determined by the time difference determining device. This allows for an especially efficient and accurate implementation of a digital phase-locked loop.

Advantageously, the digital phase-locked loop additionally comprises a feedback signal generator, adapted to generate a digitally controlled oscillator feedback signal from the digitally controlled oscillator signal, wherein the first digital signal is the digitally controlled oscillator feedback signal. Additionally, in this case, the digital phase-locked loop comprises a reference oscillator, which is adapted to generate a reference clock signal, or a reference input, adapted to receive a reference clock signal. The second digital signal in this case is the reference clock signal. This also allows for a very simple implementation.

Generally, it has to be noted that all arrangements, devices, elements, units and means and so forth described in the present application could be implemented by software or hardware elements or any kind of combination thereof. Furthermore, the devices may be processors or may comprise processors, wherein the functions of the elements, units and means described in the present applications may be implemented in one or more processors. All steps which are performed by the various entities described in the present application as well as the functionality described to be performed by the various entities are intended to mean that the respective entity is adapted to or configured to perform the respective steps and functionalities. Even if in the following description or specific embodiments, a specific functionality or step to be performed by a general entity is not reflected in the description of a specific detailed element of that entity which performs that specific step or functionality, it should be clear for a skilled person that these methods and functionalities can be implemented in respect of software or hardware elements, or any kind of combination thereof.

BRIEF DESCRIPTION OF DRAWINGS

The present invention is in the following explained in detail in relation to embodiments of the invention in reference to the enclosed drawings, in which

FIG. 1    shows a first embodiment of the inventive time difference determining device;

FIG. 2    shows a second embodiment of the inventive time difference determining device;

FIG. 3    shows a detail of a third embodiment of the inventive time difference determining device;

FIG. 4     shows details of a fourth embodiment of the inventive time difference determining device;

FIG. 5     shows details of a fifth embodiment of the inventive time difference determining device;

FIG. 6     shows a sixth embodiment of the inventive time difference determining device, and

FIG. 7     shows an embodiment of the inventive digital phase-locked loop.

<u>DESCRIPTION OF EMBODIMENTS</u>

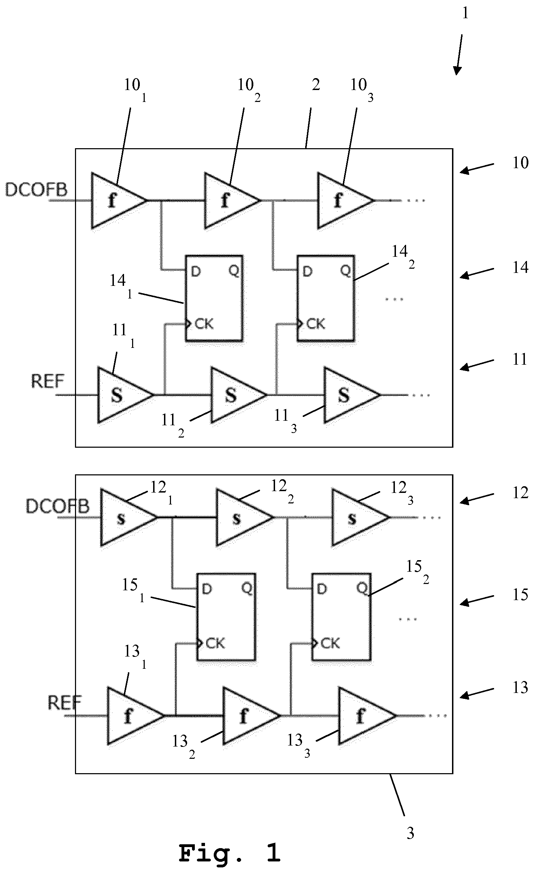

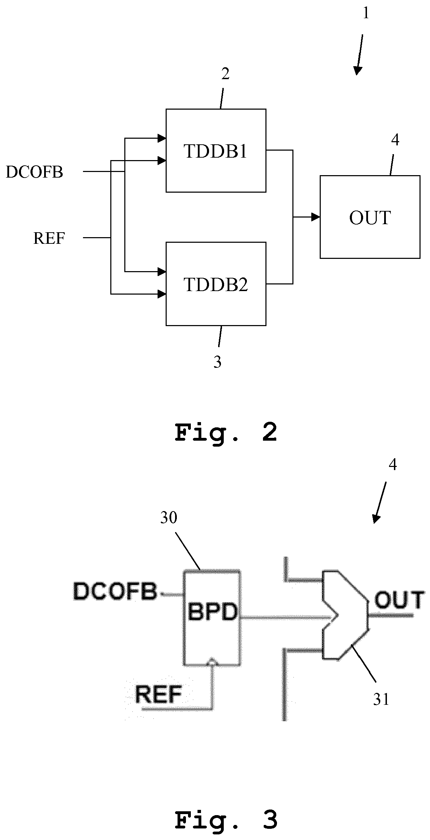

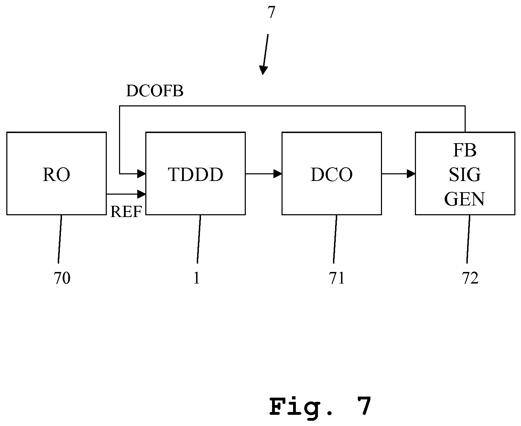

First, the general function and construction of an embodiment of the time difference determining device along FIG. 1 will be described. With regard to FIG. 2 - FIG. 6, further construction and function details of different embodiments are explained. Finally, with regard to FIG. 7, an application of the inventive time difference determining device in a digital phase-locked loop is shown and described. Similar entities and reference numbers in different figures have been partially omitted.

In FIG. 1, a first embodiment of the inventive time difference determining device 1 is shown. The invention takes advantage of the before-mentioned Vernier technique to increase the resolution compared to a classical architecture. The time difference determining device 1 comprises a first time difference determining branch 2 and a second time difference determining branch 3. Both branches 2, 3 are based on the Vernier technique. This means that both time difference determining branches 2, 3 each use two delay lines 10, 11, 12, 13.

Especially, the first time difference determining branch 2 comprises a first delay line 10 and a second delay line 11. The second time difference determining branch 3 comprises a third delay line 12 and a fourth delay line 13.

Each delay line 10, 11, 12, 13 comprises N delay cells. The first delay line 10 comprises the delay cells $10_1$, $10_2$, $10_3$. The second delay line 11 comprises the delay cells $11_1$, $11_2$, $11_3$. The third delay line 12 comprises the delay cells $12_1$, $12_2$, $12_3$. Finally, the fourth delay line comprises the delay cells $13_1$, $13_2$ and $13_3$.

Moreover, the first time difference determining branch 2 comprises N first samplers 14, individually referred to as $14_1$, $14_2$, each connected between an output of an $n^{th}$ one of the N first delay cells $10_1$, $10_2$, $10_3$ and an output of an $n^{th}$ one the N second delay cells $11_1$, $11_2$, $11_3$. The N first samplers $14_1$, $14_2$ are adapted to sample an output signal of the $n^{th}$ one of the N first delay cells $10_1$, $10_2$, $10_3$ when triggered by an output signal of the $n^{th}$ one of the N second delay cells $11_1$, $11_2$, $11_3$.

The second time difference determining branch 3 comprises N second samplers 15, individually referred to as $15_1$, $15_2$, each connected between an output of an $n^{th}$ one of the N third delay cells $12_1$, $12_2$, $12_3$ and an output of an $n^{th}$ one of the N fourth delay cells $13_1$, $13_2$, $13_3$. The N second samplers 15 are adapted to sample an output signal of the $n^{th}$ one of the N third delay cells $12_1$, $12_2$, $12_3$, when triggered by an output signal of the $n^{th}$ one of the N fourth delay cells $13_1$, $13_2$, $13_3$.

The delay cells $10_1$, $10_2$, $10_3$ of the first delay line 10 and the N fourth delay cells $13_1$, $13_2$, $13_3$ of the fourth delay line 13 have an identical first delay. This is indicated in FIG. 1 by the letter "f". The delay cells $11_1$, $11_2$, $11_3$ of the second delay line 11 as well as the third delay cells $12_1$, $12_2$, $12_3$ of the third delay line 12 have a second delay, which is higher than the first delay. This is indicated by the letter "s". The letter "f" indicates that the delay lines are fast in relation to the slower delay lines indicated by the letter "s".

The delay cells $10_1$, $10_2$, $10_3$, $11_1$, $11_2$, $11_3$, $12_1$, $12_2$, $12_3$, $13_1$, $13_2$, $13_3$ shown in FIG. 1 are buffers, for example implemented using MOS devices of the same type with different sizes or different type devices, which differ for example in threshold, oxide layer thickness etc. These differences are used to achieve the different delay times of the delay cells.

Both time difference determining branches 2, 3 are adapted to determine a time delay between a first digital signal DCOFB and a second digital signal REF.

At each delay cell $10_1$, $10_2$, $10_3$, $11_1$, $11_2$, $11_3$, $12_1$, $12_2$, $12_3$, $13_1$, $13_2$, $13_3$ of the delay lines 10, 11, 12, 13, the delay between the two input signals, delayed by the respective delay line 10, 11, 12, 13 increases by a delta. Using two identical time difference determining branches 2, 3, with swapped positions of the fast and the slow delay cells, allows for an especially efficient and low power time difference determining.

Thanks to the swapped position of the slow and fast delay lines, in both time difference determining branches 2, 3, the sampling signal is the second digital signal REF. In other words, in the first time difference determining branch 2, the relative delay of the first digital signal DCOFB and the second digital signal REF increases across the length of the delay lines 10, 11, while in the second branch 3, the delay decreases along the delay lines 12, 13.

This allows the use of the second digital signal REF as sampling frequency in both branches and covers both cases of the first digital signal DCOFB leading or the second digital signal REF leading. This again allows for a significant decrease in power consumption in comparison to existing architectures, since the sampling frequency is always the second digital signal, which typically has a significantly lower frequency than the first digital signal DCOFB. At the same time, by use of the Vernier technique, an especially high resolution is achieved.

If TS is the delay of each delay cell $11_1$, $11_2$, $11_3$ of the second delay line 11 and each delay cell $12_1$, $12_2$, $12_3$ of the third delay line 12, and if TF is the delay of each delay cell $10_1$, $10_2$, $10_3$ of the first delay line 10 and of each delay cell $13_1$,

$13_2$, $13_3$ of the fourth delay line 13, at the nth stage of the time difference determining branch P, the delay between the first digital signal DCOFB and the second digital signal REF will be:

$$\Delta TPn = \Delta Ti - n*\Delta Tu,$$

while the delay between the first digital signal DCOFB and the second digital signal REF at the nth stage of the time difference determining branch N will be:

$$\Delta TNn = \Delta Ti + n*\Delta Tu$$

where:

- $\Delta Ti$ is the initial delay between the first digital signal DCOFB and the second digital signal REF with $\Delta Ti$ positive if REF leads DCOFB and negative if REF lags DCOFB. $\Delta Ti$ is the delay that the TDC has to measure after quantization and digital conversion.
- $\Delta Tu = TS - TF$ is the unitary delta delay (i.e. the delay added to the input signals) of one Vernier delay line stage.

The time difference determining device 1 comprises the 2 time difference determining branches 2, 3, also referred to as P and N, in parallel. The output information is provided by the time difference determining branch 2, in case the REF leads the DCOFB and by the time difference determining branch 3, in case the REF lags the DCOFB.

Indeed in the time difference determining branch 2, the number N0 of bit '0' sampled by the REF signal is the digital information corresponding to the initial delay $\Delta Ti$ because a bit '0' is sampled at each stage stage if $\Delta T1n > 0$ and $\Delta Ti = N0*\Delta Tu$. Similarly on the time difference determining branch 3, the number N1 of bit '1' sampled by the REF provides the TDC output information when the REF lags the DCOFB because $\Delta Ti = N1*\Delta Tu$.

In FIG. 2, a second embodiment of the time difference determining device of the invention is shown. Here, an output stage 4 is added, which is connected to the first time difference determining branch 2 and the second time difference determining branch 3.

The information regarding which output of the time difference determining branch 2 and time difference determining branch 3 has to be selected as main time difference determining device output, can be provided by a binary phase detector as for the classical architecture or more easily by the Digital Loop Filter by comparing the two time difference determining branches' 2, 3 outputs: if CODEP starts with a bit '0' it will be the TDC output while if CODEN starts with a bit '1' it will be the TDC output.

A specific embodiment of the output stage 4 is shown in FIG. 3. Here, a binary phase detector 30 is connected to the first digital signal DCOFB and to the second digital signal REF. It decides which signal is leading and accordingly instructs an output switch 31, which either connects the output signal of the first time difference determining branch 2 or the output signal of the second time difference determining branch 2 to the output of the time difference determining device 1.

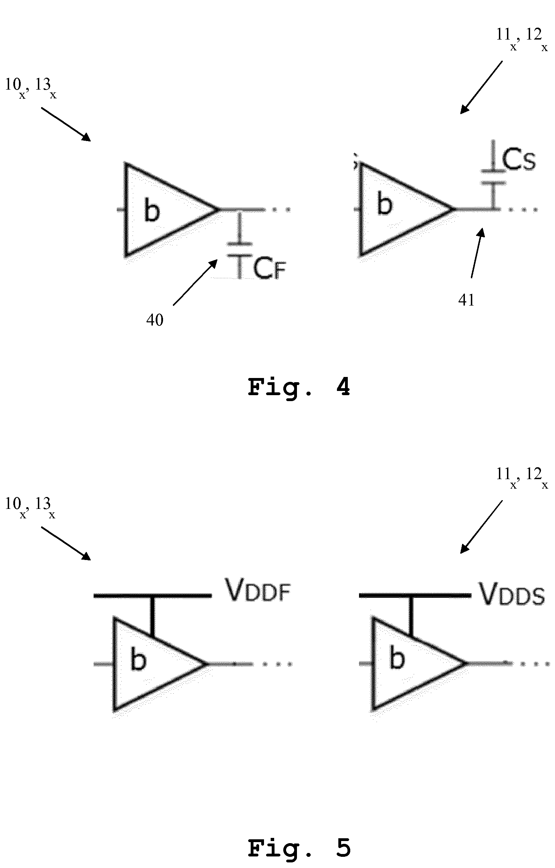

In FIG. 4, a further detail of an alternative embodiment of the time difference determining device 1 is shown. Here, all delay cells $10_1$, $10_2$, $10_3$, $11_1$, $11_2$, $11_3$, $12_1$, $12_2$, $12_3$, $13_1$, $13_2$, $13_3$, in the following also referred to as $10_x$, $11_x$, $12_x$, $13_x$ are realized by a buffer having the same characteristics, especially having the same delay but in addition an output capacitor CF, CS. The delay cells $10_x$, $13_x$, use a relatively smaller capacitor CF, resulting in a lower overall delay of the buffer in combination with the capacitor, while the delay cells $11_x$, $12_x$ use a relatively larger capacitor CS 41, which in combination with the buffer results in a longer delay of the respective delay cells. It should be noted that CF could also be zero.

A further embodiment is shown in FIG. 5. Here, the different delay times of the delay cells $10_x$, $13_x$ and the delay cells $11_x$, $12_x$ are achieved by using identical buffers for all delay cells $10_x$, $11_x$, $12_x$, $13_x$ but supplying different supply voltages thereto. Here, the delay cells $10_x$, $13_x$ are supplied with a supply voltage VDDF while the delay cells $11_x$, $12_x$ each have a buffer supplied with a supply voltage VDDS. Therein, VDDF is larger than VDDS. This results in a lower delay of the delay cells $10_x$, $13_x$ than the delay cells $11_x$, $12_x$.

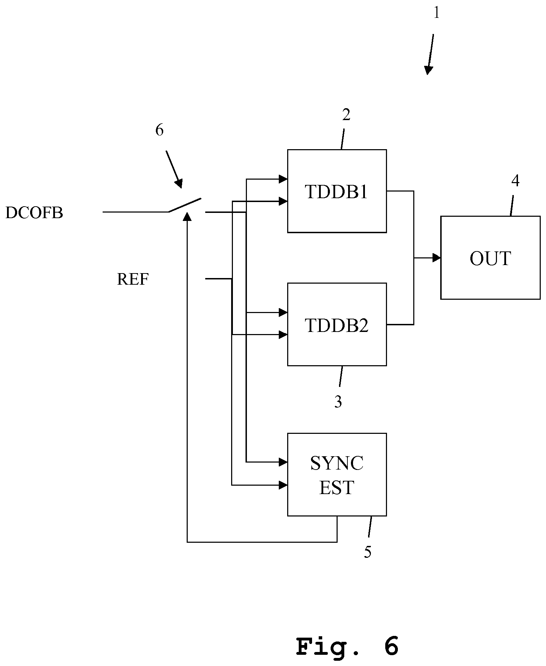

Moreover, in FIG. 6, a further embodiment of the time difference determining device 1 is shown. Here, the time difference determining device 1 additionally comprises a synchronization estimator 5. This synchronization estimator 5 serves the purpose of estimating a time difference between the first digital signal DCOFB and the second digital signal REF. Especially, it determines an estimate time of synchronization of pulses of the first digital signal DCOFB and the second digital signal REF. The synchronization estimator 5 is connected to a switch 6, which connects and disconnects the first digital signal DCOFB to the time difference determining branches 2, 3. While the synchronization estimator 5 estimates a synchronization time, it closes the switch 6, while opening it at all other times. This results in the time difference determining branches 2, 3 only operating, around the time of estimated synchronization. This results in a significant reduction of the power consumption, since the time difference determining branches 2, 3 only consume power while they are actually operating.

Moreover, in FIG. 7, an application of the time difference determining device 1 in a digital phase-locked loop 7 is shown. Here, a reference oscillator 70 or alternatively a not-drawn reference signal input provides the second digital signal REF. It is provided to the time difference determining device 1, which receives the first digital signal DCOFB in addition. The time difference determining device 1 determines the time difference between the first digital signal DCOFB and the second digital signal REF and hands it to a digitally controlled oscillator 71, which is adapted to generate a digitally controlled oscillator signal, controlled by the time difference between the first digital signal DCOFB and the second digital signal REF. This digitally controlled oscillator signal is then handed to a feedback signal generator 71, which generates a digitally controlled oscillator feedback signal from the digitally controlled oscillator signal, which is identical to the first digital signal. This feedback closes the digital phase-locked loop. The output signal of the digitally controlled oscillator 71 is the output signal of the digital phase-locked loop 7.

The invention is not limited to the provided examples. Especially, instead of using a buffer, also an inverter or another delay element can be used within the delay cells. Also, the embodiments show a specific number of delay cells in the delay lines, this is though not to be understood as limiting. Any number of delay cells above 1 can be used. Also, the shown examples regarding the technologies employed are not to be understood as limiting. The characteristics of the exemplary embodiments can be used in any advantageous combination.

The invention has been described in conjunction with various embodiments herein. However, other variations to the disclosed embodiments can be understood and effected by those skilled in the art in practicing the claimed invention, from a study of the drawings, the disclosure and the appended claims. In the claims, the word "comprising " does not exclude other elements or steps and the indefinite article "a" or "an" does not exclude a plurality. A single processor or other unit may fulfill the functions of several items recited in the claims. The mere fact that certain measures are recited in usually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the internet or other wired or wireless communication systems.

**Claims**

1.    Time difference determining device (1) for determining a time difference between a first digital signal (DCOFB) and a second digital signal (REF), comprising:

- a first time difference determining branch (2), comprising:

- a first delay line (10), comprising N first delay cells (101, 102, 103), each of the N first delay cells (101, 102, 103) having a first delay (f),
- a second delay line (11), comprising N second delay cells (111, 112, 113), each of the N second delay cells (111, 112, 113) having a second delay (s), the second delay (s) being higher than the first delay (f),

- a second time difference determining branch (3), comprising:

- a third delay line (12), comprising N third delay cells (121, 122, 123), each of the N third delay cells (121, 122, 123) having the second delay (s),
- a fourth delay line (13), comprising N fourth delay cells (131, 132, 133), each of the N fourth delay cells (131, 132, 133) having the first delay (f),

- N first samplers (14, 141, 142), each connected between an output of an $n^{th}$ one of the N first delay cells (101, 102, 103) and an output of an $n^{th}$ one of the N second delay cells (111, 112, 113), adapted to sample an output signal of the $n^{th}$ one of the N first delay cells (101, 102, 103), when triggered by an output signal of the $n^{th}$ one of the N second delay cells (111, 112, 113),
- N second samplers (15, 151, 152), each connected between an output of an $n^{th}$ one of the N third delay cells (121, 122, 123) and an output of an $n^{th}$ one of the N fourth delay cells (131, 132, 133), adapted to sample an output signal of the $n^{th}$ one of the N third delay cells (121, 122, 123), when triggered by an output signal of the $n^{th}$ one of the N fourth delay cells (131, 132, 133), and
- an output stage (4), configured to:

- receive as first input signal an output of the first time difference determining branch (2) and as second input signal an output of the second time difference determining branch (3); and
- select as an output of the Time difference determining device (1):

- the first input signal, if a 1st output bit of both time difference determining branches have a bit value "0";
- the second input signal, if a 1st output bit of both time difference determining branches have a bit value "1";
- a value "0", indicating no time difference between the first digital signal (DCOFB) and the second digital signal (REF), if the 1st output bit of the first time difference determining branch (2) has a bit value "0" and the 1st output bit of the second time difference determining branch (3) has a bit value "1";
- a value "0", indicating no time difference between the first digital signal (DCOFB) and the second digital signal (REF), if the 1st output bit of the first time difference determining branch (2) has a bit value "1" and the 1st output bit of the second time difference determining branch (3) has a bit value "0", and

wherein the first digital signal (DCOFB) is connected to an input of the first delay line (10) and to an input of the third delay line (12), and
wherein the second digital signal (REF) is connected to an input of the second delay line (11) and to an input of the fourth delay line (13).

2. Time difference determining device (1) according to claim 1,
wherein the first digital signal (DCOFB) and the second digital signal (REF) are rectangle signals, and/or wherein a pulse frequency of the first digital signal (DCOFB) is higher than a pulse frequency of the second digital signal (REF).

3. Time difference determining device (1) according to claim 1 or 2,

wherein all delay cells of the first delay line (10) and all delay cells of the fourth delay line (13) are buffers or inverters having the first delay (f), and
wherein all delay cells of the second delay line (11) and all delay cells of the third delay line (12) are buffers or inverters having the second delay (f).

4. Time difference determining device (1) according to any of the claims 1 to 3,

wherein all delay cells of the first delay line (10), all delay cells of the second delay line (11), all delay cells of the third delay line (12), and all delay cells of the fourth delay line (13) comprise buffers having a third delay,
wherein all delay cells of the first delay line (10), and all delay cells of the fourth delay line (13) comprise an output capacitor ($C_F$) of a first capacitance, the combination of the respective buffer and output capacitor ($C_F$) leading to the first delay (f) of the respective delay cell, and
wherein all delay cells of the second delay line (11), and all delay cells of the third delay line (12) comprise an output capacitor (Cs) of a second capacitance, the combination of the respective buffer and output capacitor (Cs) leading to the second delay (f) of the respective delay cell.

5. Time difference determining device (1) according to claim 1 or 2,

wherein all delay cells of the first delay line (10), all delay cells of the second delay line (11), all delay cells of the third delay line (12), and all delay cells of the fourth delay line (13) comprise a buffer having a fourth delay,
wherein all delay cells of the first delay line (10), and all delay cells of the fourth delay line (13) are connected to a first supply voltage (VDDF), leading to the first delay (f) of the respective delay cell, and
wherein all delay cells of the second delay line (11), and all delay cells of the third delay line (12) are connected to a second supply voltage (VDDS), lower than the first supply voltage (VDDF), leading to the second delay (f) of the respective delay cell.

6. Time difference determining device (1) according to any of the claims 1 to 5, comprising

- a synchronization estimator (5), adapted to determine an estimate time of synchronization of pulses of the first digital signal (DCOFB) and the second digital signal (REF), and
- an activation switch (6), adapted to selectively disconnect and connect the first digital signal (DCOFB) from the first delay line (10) and from the third delay line (12), based on the determined estimate time.

7. Time difference determining device (1) according to claim 6,

wherein the synchronization estimator (5) is a frequency counter.

8. Digital phase locked loop, comprising

- a time difference determining device (1) according to any of the claims 1 to 7, and
- a digitally controlled oscillator (71), adapted to generate a digitally controlled oscillator signal, controlled by the time difference between the first digital signal (DCOFB) and the second digital signal (REF), determined by the time difference determining device (1).

9. Digital phase locked loop according to claim 8, comprising

- a feedback signal generator (72), adapted to generate a digitally controlled oscillator feedback signal from the digitally controlled oscillator signal, wherein the first digital signal (DCOFB) is the digitally controlled oscillator feedback signal, and
- a reference oscillator (70), adapted to generate a reference clock signal, or a reference input, adapted to receive a reference clock signal, wherein the second digital signal (REF) is the reference clock signal.


**Patentansprüche**

1. Zeitdifferenzbestimmungsvorrichtung (1) zum Bestimmen einer Zeitdifferenz zwischen einem ersten digitalen Signal (DCOFB) und einem zweiten digitalen Signal (REF), die umfasst:

- einen ersten Zeitdifferenzbestimmungszweig (2), der umfasst:

- eine erste Verzögerungsleitung (10), die N erste Verzögerungszellen (101, 102, 103) umfasst, wobei jede der N ersten Verzögerungszellen (101, 102, 103) eine erste Verzögerung (f) aufweist,
- eine zweite Verzögerungsleitung (11), die N zweite Verzögerungszellen (111, 112, 113) umfasst, wobei jede der N zweiten Verzögerungszellen (111, 112, 113) eine zweite Verzögerung (s) aufweist, wobei die zweite Verzögerung (s) höher als die erste Verzögerung (f) ist,
- einen zweiten Zeitdifferenzbestimmungszweig (3), der umfasst:

- eine dritte Verzögerungsleitung (12), die N dritte Verzögerungszellen (121, 122, 123) umfasst, wobei jede der N dritten Verzögerungszellen (121, 122, 123) die zweite Verzögerung (s) aufweist,
- eine vierte Verzögerungsleitung (13), die N vierte Verzögerungszellen (131, 132, 133) umfasst, wobei jede der N vierten Verzögerungszellen (131, 132, 133) die erste Verzögerung (f) aufweist,
- N erste Abtaster (14, 141, 142), wobei jeder zwischen einem Ausgang einer n-ten der N ersten Verzögerungszellen (101, 102, 103) und einem Ausgang einer n-ten der N zweiten Verzögerungszellen (111, 112, 113) verbunden ist, die angepasst sind, um ein Ausgangssignal der n-ten der N ersten Verzögerungszellen (101, 102, 103), wenn durch ein Ausgangssignal der n-ten der N zweiten Verzögerungszellen (111, 112, 113) ausgelöst, abzutasten,
- N zweite Abtaster (15, 151, 152), wobei jeder zwischen einem Ausgang einer n-ten der N dritten Verzögerungszellen (121, 122, 123) und einem Ausgang einer n-ten der N vierten Verzögerungszellen (131, 132, 133) verbunden ist, die angepasst sind, um ein Ausgangssignal der n-ten der N dritten Verzögerungszellen (121, 122, 123), wenn durch ein Ausgangssignal der n-ten der N vierten Verzögerungszellen (131, 132, 133) ausgelöst, abzutasten und
- eine Ausgangsstufe (4), die konfiguriert ist zum:

- Empfangen, als erstes Eingangssignal, eines Ausgangs des ersten Zeitdifferenzbestimmungszweigs (2) und, als zweites Eingangssignal, eines Ausgangs des zweiten Zeitdifferenzbestimmungszweigs (3); und
- Auswählen als einen Ausgang der Zeitdifferenzbestimmungsvorrichtung (1):

- des ersten Eingangssignals, falls ein 1. Ausgangsbit von beiden Zeitdifferenzbestimmungszweigen einen Bitwert "0" aufweist;
- des zweiten Eingangssignals, falls ein 1. Ausgangsbit von beiden Zeitdifferenzbestimmungszweigen einen Bitwert "1" aufweist;
- eines Werts "0", der keine Zeitdifferenz zwischen dem ersten digitalen Signal (DCOFB) und dem zweiten digitalen Signal (REF) anzeigt, falls das 1. Ausgangsbit des ersten Zeitdifferenzbestimmungszweigs (2) einen Bitwert "0" aufweist und das 1. Ausgangsbit des zweiten Zeitdifferenzbestimmungszweigs (3) einen Bitwert "1" aufweist;
- eines Werts "0", der keine Zeitdifferenz zwischen dem ersten digitalen Signal (DCOFB) und dem zweiten digitalen Signal (REF) anzeigt, falls das 1. Ausgangsbit des ersten Zeitdifferenzbestimmungszweigs (2) einen Bitwert "1" aufweist und das 1. Ausgangsbit des zweiten Zeitdifferenzbestimmungszweigs (3) einen Bitwert "0" aufweist und

wobei das erste digitale Signal (DCOFB) mit einem Eingang der ersten Verzögerungsleitung (10) und mit einem Eingang der dritten Verzögerungsleitung (12) verbunden ist und wobei das zweite digitale Signal (REF) mit einem Eingang der zweiten Verzögerungsleitung (11) und mit einem Eingang der vierten Verzögerungsleitung (13) verbunden ist.

2. Zeitdifferenzbestimmungsvorrichtung (1) nach Anspruch 1,
wobei das erste digitale Signal (DCOFB) und das zweite digitale Signal (REF) Rechtecksignale sind, und/oder wobei eine Pulsfrequenz des ersten digitalen Signals (DCOFB) höher als eine Pulsfrequenz des zweiten digitalen Signals (REF) ist.

3. Zeitdifferenzbestimmungsvorrichtung (1) nach Anspruch 1 oder 2,

wobei alle Verzögerungszellen der ersten Verzögerungsleitung (10) und alle Verzögerungszellen der vierten Verzögerungsleitung (13) Puffer oder Inverter, die die erste Verzögerung (f) aufweisen, sind und
wobei alle Verzögerungszellen der zweiten Verzögerungsleitung (11) und alle Verzögerungszellen der dritten Verzögerungsleitung (12) Puffer oder Inverter, die die zweite Verzögerung (f) aufweisen, sind.

4. Zeitdifferenzbestimmungsvorrichtung (1) nach einem der Ansprüche 1 bis 3,

wobei alle Verzögerungszellen der ersten Verzögerungsleitung (10), alle Verzögerungszellen der zweiten Verzögerungsleitung (11), alle Verzögerungszellen der dritten Verzögerungsleitung (12) und alle Verzögerungszellen der vierten Verzögerungsleitung (13) Puffer, die eine dritte Verzögerung aufweisen, umfassen, wobei alle Verzögerungszellen der ersten Verzögerungsleitung (10) und alle Verzögerungszellen der vierten Verzögerungsleitung (13) einen Ausgangskondensator ($C_F$) einer ersten Kapazität umfassen, wobei die Kombination des jeweiligen Puffers und Ausgangskondensators ($C_F$) zu der ersten Verzögerung (f) der jeweiligen Verzögerungszelle führt und
wobei alle Verzögerungszellen der zweiten Verzögerungsleitung (11) und alle Verzögerungszellen der dritten Verzögerungsleitung (12) einen Ausgangskondensator ($C_S$) einer zweiten Kapazität umfassen, wobei die Kombination des jeweiligen Puffers und Ausgangskondensators ($C_S$) zu der zweiten Verzögerung (f) der jeweiligen Verzögerungszelle führt.

5. Zeitdifferenzbestimmungsvorrichtung (1) nach Anspruch 1 oder 2,

wobei alle Verzögerungszellen der ersten Verzögerungsleitung (10), alle Verzögerungszellen der zweiten Verzögerungsleitung (11), alle Verzögerungszellen der dritten Verzögerungsleitung (12) und alle Verzögerungszellen der vierten Verzögerungsleitung (13) einen Puffer, der eine vierte Verzögerung aufweist, umfassen,
wobei alle Verzögerungszellen der ersten Verzögerungsleitung (10) und alle Verzögerungszellen der vierten Verzögerungsleitung (13) mit einer ersten Versorgungsspannung (VDDF) verbunden sind, was zu der ersten Verzögerung (f) der jeweiligen Verzögerungszelle führt, und wobei alle Verzögerungszellen der zweiten Verzögerungsleitung (11) und alle Verzögerungszellen der dritten Verzögerungsleitung (12) mit einer zweiten Versorgungsspannung (VDDS), die niedriger als die erste Versorgungsspannung (VDDF) ist, verbunden sind, was zu der zweiten Verzögerung (f) der jeweiligen Verzögerungszelle führt.

6. Zeitdifferenzbestimmungsvorrichtung (1) nach einem der Ansprüche 1 bis 5, die umfasst

- einen Synchronisationsschätzer (5), der angepasst ist, um eine geschätzte Synchronisationszeit von Impulsen des ersten digitalen Signals (DCOFB) und des zweiten digitalen Signals (REF) zu bestimmen und
- einen Aktivierungsschalter (6), der angepasst ist, um das erste digitale Signal (DCOFB) basierend auf der bestimmten geschätzten Zeit von der ersten Verzögerungsleitung (10) und von der dritten Verzögerungsleitung (12) selektiv zu trennen und zu verbinden.

**7.** Zeitdifferenzbestimmungsvorrichtung (1) nach Anspruch 6,
wobei der Synchronisationsschätzer (5) ein Frequenzzähler ist.

**8.** Digitaler Phasenregelkreis, der umfasst

- eine Zeitdifferenzbestimmungsvorrichtung (1) nach einem der Ansprüche 1 bis 7 und
- einen digital gesteuerten Oszillator (71), der angepasst ist, um ein digital gesteuertes Oszillatorsignal zu erzeugen, das durch die Zeitdifferenz zwischen dem ersten digitalen Signal (DCOFB) und dem zweiten digitalen Signal (REF), die von der Zeitdifferenzbestimmungsvorrichtung (1) bestimmt werden, gesteuert wird.

**9.** Digitaler Phasenregelkreis nach Anspruch 8, der umfasst

- einen Rückkopplungssignalgenerator (72), der angepasst ist, um ein digital gesteuertes Oszillatorrückkopplungssignal von dem digital gesteuerten Oszillatorsignal zu erzeugen, wobei das erste digitale Signal (DCOFB) das digital gesteuerte Oszillatorrückkopplungssignal ist und
- einen Referenzoszillator (70), der angepasst ist, um ein Referenztaktsignal oder einen Referenzeingang, der angepasst ist, um ein Referenztaktsignal zu empfangen, zu erzeugen, wobei das zweite digitale Signal (REF) das Referenztaktsignal ist.

**Revendications**

**1.** Dispositif de détermination de différence de temps (1) permettant de déterminer une différence de temps entre un premier signal numérique (DCOFB) et un second signal numérique (REF), comprenant :

- une première branche de détermination de différence de temps (2), comprenant :

- une première ligne à retard (10), comprenant N premières cellules à retard (101, 102, 103), chacune des N premières cellules à retard (101, 102, 103) ayant un premier retard (f),
- une deuxième ligne à retard (11), comprenant N deuxièmes cellules à retard (111, 112, 113), chacune des N deuxièmes cellules à retard (111, 112, 113) ayant un deuxième retard (s), le deuxième retard (s) étant supérieur au premier retard (f),
- une seconde branche de détermination de différence de temps (3), comprenant :

- une troisième ligne à retard (12), comprenant N troisièmes cellules à retard (121, 122, 123), chacune des N troisièmes cellules à retard (121, 122, 123) ayant le deuxième retard (s),
- une quatrième ligne à retard (13), comprenant N quatrièmes cellules à retard (131, 132, 133), chacune des N quatrièmes cellules à retard (131, 132, 133) ayant le premier retard (f),
- N premiers échantillonneurs (14, 141,142), chacun connecté entre une sortie d'une $n^{ième}$ première cellule à retard des N premières cellules à retard (101, 102, 103) et une sortie d'une $n^{ième}$ deuxième cellule à retard des N deuxièmes cellules à retard (111, 112, 113), adaptés à échantillonner un signal de sortie de la $n^{ième}$ première cellule à retard des N premières cellules à retard (101, 102, 103), lorsqu'ils sont déclenchés par un signal de sortie de la $n^{ième}$ deuxième cellule à retard des N deuxièmes cellules à retard (111, 112, 113),
- N seconds échantillonneurs (15, 151, 152), chacun connecté entre une sortie d'une $n^{ième}$ troisième cellule à retard des N troisièmes cellules à retard (121, 122, 123) et une sortie d'une $n^{ième}$ quatrième cellule à retard des N quatrièmes cellules à retard (131, 132, 133), adaptés à échantillonner un signal de sortie de la $n^{ième}$ troisième cellule à retard des N troisièmes cellules à retard (121, 122, 123), lorsqu'ils sont déclenchés par un signal de sortie de la $n^{ième}$ quatrième cellule à retard des N quatrièmes cellules à retard (131, 132, 133), et
- un étage de sortie (4), configuré pour :

- recevoir comme premier signal d'entrée une sortie de la première branche de détermination de différence de temps (2) et comme second signal d'entrée une sortie de la seconde branche de détermination de différence de temps (3) ; et
- sélectionner comme sortie du dispositif de détermination de différence de temps (1) :

- le premier signal d'entrée, si un $1^{er}$ bit de sortie des deux branches de détermination de différence de temps a une valeur de bit " 0 " ;
- le second signal d'entrée, si un 1er bit de sortie des deux branches de détermination de différence de temps a une valeur de bit " 1 " ;
- une valeur " 0 " indiquant qu'il n'y a pas de différence de temps entre le premier signal numérique (DCOFB) et le second signal numérique (REF), si le 1er bit de sortie de la première branche de détermination de différence de temps (2) a une valeur de bit " 0 " et le 1er bit de sortie de la seconde branche de détermination de différence de temps (3) a une valeur de bit " 1 " ;
- une valeur " 0 " indiquant qu'il n'y a pas de différence de temps entre le premier signal numérique (DCOFB) et le second signal numérique (REF), si le 1er bit de sortie de la première branche de détermination de différence de temps (2) a une valeur de bit " 1 " et le 1er bit de sortie de la seconde branche de détermination de différence de temps (3) a une valeur de bit " 0 ", et dans lequel le premier signal numérique (DCOFB) est connecté à une entrée de la première ligne à retard (10) et à une entrée de la troisième ligne à retard (12), et dans lequel le second signal numérique (REF) est connecté à une entrée de la deuxième ligne à retard (11) et à une entrée de la quatrième ligne à retard (13).

2. Dispositif de détermination de différence de temps (1) selon la revendication 1, dans lequel le premier signal numérique (DCOFB) et le second signal numérique (REF) sont des signaux rectangulaires, et/ou dans lequel une fréquence d'impulsion du premier signal numérique (DCOFB) est supérieure à une fréquence d'impulsion du second signal numérique (REF).

3. Dispositif de détermination de différence de temps (1) selon la revendication 1 ou 2, dans lequel toutes les cellules à retard de la première ligne à retard (10) et toutes les cellules à retard de la quatrième ligne à retard (13) sont des tampons ou des inverseurs ayant le premier retard (f), et dans lequel toutes les cellules à retard de la deuxième ligne à retard (11) et toutes les cellules à retard de la troisième ligne à retard (12) sont des tampons ou des inverseurs ayant le deuxième retard (f).

4. Dispositif de détermination de différence de temps (1) selon l'une quelconque des revendications 1 à 3,

dans lequel toutes les cellules à retard de la première ligne à retard (10), toutes les cellules à retard de la deuxième ligne à retard (11), toutes les cellules à retard de la troisième ligne à retard (12), et toutes les cellules à retard de la quatrième ligne à retard (13) comprennent des tampons ayant un troisième retard,
dans lequel toutes les cellules à retard de la première ligne à retard (10), et toutes les cellules à retard de la quatrième ligne à retard (13) comprennent un condensateur de sortie ($C_F$) d'une première capacité, la combinaison du tampon et du condensateur de sortie ($C_F$) respectifs conduisant au premier retard (f) de la cellule à retard respective, et
dans lequel toutes les cellules à retard de la deuxième ligne à retard (11), et toutes les cellules à retard de la troisième ligne à retard (12) comprennent un condensateur de sortie ($C_S$) d'une seconde capacité, la combinaison du tampon et du condensateur de sortie ($C_S$) respectifs conduisant au deuxième retard (f) de la cellule à retard respective.

5. Dispositif de détermination de différence de temps (1) selon la revendication 1 ou 2, dans lequel toutes les cellules à retard de la première ligne à retard (10), toutes les cellules à retard de la deuxième ligne à retard (11), toutes les cellules à retard de la troisième ligne à retard (12), et toutes les cellules à retard de la quatrième ligne à retard (13) comprennent un tampon ayant un quatrième retard, dans lequel toutes les cellules à retard de la première ligne à retard (10), et toutes les cellules à retard de la quatrième ligne à retard (13) sont connectées à une première tension d'alimentation (VDDF), conduisant au premier retard (f) de la cellule à retard respective, et dans lequel toutes les cellules à retard de la deuxième ligne à retard (11), et toutes les cellules à retard de la troisième ligne à retard (12) sont connectées à une seconde tension d'alimentation (VDDS), inférieure à la première tension d'alimentation (VDDF), conduisant au deuxième retard (f) de la cellule à retard respective.

6. Dispositif de détermination de différence de temps (1) selon l'une quelconque des revendications 1 à 5, comprenant

- un estimateur de synchronisation (5), adapté à déterminer un temps estimé de synchronisation d'impulsions du premier signal numérique (DCOFB) et du second signal numérique (REF), et
- un commutateur d'activation (6), adapté à déconnecter et connecter sélectivement le premier signal numérique (DCOFB) de la première ligne à retard (10) et de la troisième ligne à retard (12), sur la base du temps estimé déterminé.

7. Dispositif de détermination de différence de temps (1) selon la revendication 6, dans lequel l'estimateur de synchronisation (5) est un compteur de fréquence.

8. Boucle numérique à verrouillage de phase, comprenant

   - un dispositif de détermination de différence de temps (1) selon l'une quelconque des revendications 1 à 7, et
   - un oscillateur à commande numérique (71), adapté à générer un signal d'oscillateur à commande numérique, commandé par la différence de temps entre le premier signal numérique (DCOFB) et le second signal numérique (REF), déterminée par le dispositif de détermination de différence de temps (1).

9. Boucle numérique à verrouillage de phase selon la revendication 8, comprenant

   - un générateur de signal de retour (72), adapté à générer un signal de retour d'oscillateur à commande numérique à partir du signal d'oscillateur à commande numérique, dans lequel le premier signal numérique (DCOFB) est le signal de retour d'oscillateur à commande numérique, et
   - un oscillateur de référence (70), adapté à générer un signal d'horloge de référence, ou une entrée de référence, adaptée à recevoir un signal d'horloge de référence, dans lequel le second signal numérique (REF) est le signal d'horloge de référence.

Fig. 1

Fig. 2

Fig. 3

$10_x, 13_x$

$11_x, 12_x$

$C_S$

$C_F$

40

41

**Fig. 4**

$10_x, 13_x$

$11_x, 12_x$

$V_{DDF}$

$V_{DDS}$

b

b

**Fig. 5**

Fig. 6

7

DCOFB

| RO | TDDD | DCO | FB SIG GEN |

REF

70    1    71    72

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007273569 A1
- US 2011133973 A1
- EP 2940872 A1

- US 2015212494 A1
- US 2002158662 A1
- US 8081013 B1

**Non-patent literature cited in the description**

- A 0.6 V, 1.74 ps Resolution Capacitively Boosted Time-to-Digital Converter in 180 nm CMOS. **PALA-NIAPPAN ARJUN RAMASWAMI et al.** 2019 IEEE INTERNATIONAL SYMPOSIUM ON CIRCUITS AND SYSTEMS (ISCAS). IEEE, 26 May 2019

- An ADPLL with a MASH 1-1-1 [Delta][Sigma] Time-digital c. **WANG ZIXUAN et al.** MELECON 2014 - 2014 17TH IEEE MEDITERRANEAN ELECTRO-TECHNICAL CONFERENCE. IEEE, 14 April 2014